# DEMANDE DE BREVET EUROPEEN

(11) **EP 4 390 781 A1**
(43) Date de publication de la demande: **26.06.2024**
(21) Numéro de dépôt: 23218412.7
(22) Date de dépôt: 20.12.2023
(51) Int. Cl.: G06N 10/40, H03M 1/66, G11C 27/02, H01L 29/423

(54) **CIRCUIT ÉLECTRONIQUE DE PILOTAGE D'UN CIRCUIT QUANTIQUE ET CALCULATEUR QUANTIQUE ASSOCIÉ**

(30) Priorité: 21.12.2022 FR 2214144
(71) Demandeur: Commissariat à l'énergie atomique et aux énergies alternatives, 75015 Paris (FR)
(72) Inventeur: JADOT, Baptiste, 91191 GIF SUR YVETTE CEDEX (FR); BILLIOT, Gérard, 91191 GIF SUR YVETTE CEDEX (FR); THONNART, Yvain, 91191 GIF SUR YVETTE CEDEX (FR)
(74) Mandataire: Lavoix

(57) **Abrégé**

Ce circuit (100), relié au circuit quantique par des lignes de polarisation (11, 12, 13, 14), comporte : un convertisseur numérique analogique - DAC (102) délivrant une tension analogique (Ve) ; des cellules mémoires (110, 120, 130, 140), connectées en parallèle en sortie du DAC, chaque cellule mémoire comportant un interrupteur (I1, I2, I3, I4) et une capacité (C1, C2, C3, C4), la capacité mémorisant un niveau de potentiel auquel maintenir une ligne de polarisation connectée en sortie de la cellule mémoire ; et, un moyen de génération de signaux de commande (104) générant, en synchronisation avec le DAC, un signal de commande pour chaque interrupteur de chaque cellule mémoire, le signal de commande, une valeur de la capacité d'une cellule mémoire étant sélectionnée pour rendre négligeable une capacité parasite affectant la ligne de polarisation reliée à ladite cellule mémoire et qui circule parallèlement à une ligne de polarisation voisine.

## Description

L'invention a pour domaine celui des circuits électroniques de pilotage d'un circuit quantique, placés en interface entre le circuit quantique, à température cryogénique, et une électronique haut-niveau, à température ambiante ou intermédiaire.

Un circuit quantique comporte une pluralité de qubits, c'est-à-dire de systèmes quantiques à deux états. Dans un circuit quantique à qubit de spin, un puits quantique piège une charge unique, de sorte que, selon une grandeur observable particulière, cette charge peut être dans deux états possibles. L'état courant de cette grandeur observable définit la valeur (0 ou 1) du qubit. Dans un qubit de spin, la grandeur observable est le spin de la charge selon une direction prédéfinie.

Pour établir et configurer un puits quantique dans lequel piéger une charge, un signal électrostatique est appliqué sur au moins une ligne de polarisation dont l'extrémité distale est placée à proximité immédiate de l'endroit où est situé le puits quantique.

Ainsi, le circuit quantique est muni d'une pluralité de lignes de polarisation.

Le document L. GECK et al. "Control Electronics For Semiconductor Spin Qubits", ARXIV.ORG, CORNELL UNIVERSITY LIBRARY, 201 OLIN LIBRARY CORNELL UNIVERSITY ITHACA, NY 14853, 12 mars 2019 (2019-03-12), XP081132552, divulgue la structure d'une électronique d'un ordinateur quantique à qubits. Cette électronique comporte une unité de génération de biais, propre à convertir une valeur mémorisée dans une unité de mémoire en une tension appliquée aux lignes de polarisation, l'unité de génération de biais comportant un DAC suivi d'un circuit de polarisation. Ce dernier comporte une pluralité de cellules mémoire, disposées en parallèle en sortie du DAC, chaque cellule comportant un interrupteur commandé et un condensateur stockage du potentiel de biais auquel doit être portée l'électrode connectée en sortie de la cellule mémoire.

Le document US 10 635 990 B1 décrit un circuit électronique de pilotage d'un circuit quantique. Ce circuit électronique comporte : un convertisseur numérique analogique - DAC (« Digital to Analog Converter » en anglais) permettant de générer différents niveaux de potentiel statique ; une pluralité de cellules mémoire, chaque cellule mémoire étant dédiée à la mémorisation d'un niveau de potentiel statique qui lui est propre et qui est fourni en sortie du DAC ; et une matrice de commutation permettant, à un instant particulier du fonctionnement du circuit quantique, de porter à un niveau de potentiel statique requis une ligne de polarisation particulière, en connectant la sortie de la cellule mémoire mémorisant le niveau de potentiel statique requis, à la ligne de polarisation considérée.

L'intérêt de ce circuit électronique de l'état de la technique est de permettre le placement du DAC dans le domaine à température ambiante (300 K) ou intermédiaire (4 K) et les différentes cellules mémoire dans le domaine cryogénique (entre 10 et 100 mK) avec le circuit quantique, de manière à réduire le nombre de liaisons entre ces deux domaines de température.

Cependant, les lignes de polarisation du circuit quantique ont une forte densité, au moins à proximité des qubits, de sorte qu'il existe un couplage capacitif parasite entre deux lignes de polarisation voisines circulant parallèlement.

Les lignes étant trop proches (typiquement une centaine de nm), elles ne peuvent pas être isolées pour supprimer ce couplage capacitif parasite.

Or, ce couplage est de nature à modifier le potentiel électrostatique porté par une ligne de polarisation lorsque le potentiel électrostatique porté par la ligne de polarisation voisine est modifié.

Une telle modification du potentiel électrostatique sur une ligne de polarisation a de nombreux effets négatifs, notamment d'altérer la conformation du puits quantique, ce qui peut perturber la fréquence de résonance du qubit, et donc affecter sa manipulation sa configuration et sa lecture. Dans le pire des cas, on peut perdre le confinement du puits quantique et perdre la charge (ou faire entrer une deuxième charge dans le puits).

Or, le circuit électronique de pilotage de l'état de la technique ne permet pas de répondre à cette problématique du couplage capacitif parasite entre lignes de polarisation voisines.

Il est à noter que pour un circuit quantique constitué d'une matrice bidimensionnelle de qubits, il existe un couplage capacitif parasite entre une ligne de polarisation circulant « horizontalement » et une ligne de polarisation circulant « verticalement » à l'endroit où ces lignes se croisent. Cependant, le couplage capacitif parasite correspondant est alors de plusieurs ordres de grandeur inférieur au couplage capacitif parasite qui existe entre deux lignes de polarisation « horizontales » ou deux lignes de polarisation « verticales » voisines.

De manière similaire, il existe un couplage capacitif parasite entre deux lignes de polarisation circulant parallèlement, mais qui ne sont pas immédiatement voisines l'une de l'autre, une autre ligne de polarisation étant intercalée entre ces deux lignes. Non seulement la distance entre les deux lignes considérées, mais surtout l'écrantage dû à la ligne intercalée font que le couplage capacitif parasite correspondant est d'au moins un ordre de grandeur inférieur (typiquement 30 fois inférieur) au couplage capacitif parasite qui existe entre deux lignes de polarisation parallèle voisines.

L'invention a donc pour but de proposer un circuit électronique de pilotage d'un circuit quantique de qubits permettant de limiter les effets des couplages capacitifs perturbateurs entre les lignes de polarisation voisines circulant parallèlement, tout en conservant un nombre limité de connexions entre les différents domaines de température.

Pour cela l'invention a pour objet un circuit électronique de pilotage d'un circuit quantique et un calculateur quantique selon les revendications annexées.

L'invention et ses avantages seront mieux compris à la lecture de la description détaillée qui va suivre de plusieurs modes de réalisation particuliers, donnés uniquement à titre d'exemples illustratifs et non limitatifs, la description étant faite en se référant aux dessins annexés sur lesquels :
- [Fig.1] La figure 1 est une représentation schématique d'un premier mode de réalisation d'un circuit électronique d'interface pour un circuit quantique ;
- [Fig.2] La figure 2 est un chronogramme représentant l'évolution temporelle des différents signaux impliqués dans le fonctionnement du circuit électronique de la figure 1 ;
- [Fig.3] La figure 3 est une représentation schématique d'un second mode de réalisation d'un circuit électronique d'interface pour un circuit quantique ;
- [Fig.4] La figure 4 est un chronogramme représentant l'évolution temporelle des différents signaux impliqués dans le fonctionnement du circuit électronique de la figure 3 ;
- [Fig.5] La figure 5 est une représentation schématique d'un troisième mode de réalisation d'un circuit électronique d'interface pour un circuit quantique ;
- [Fig.6] La figure 6 est un chronogramme représentant l'évolution temporelle des différents signaux impliqués dans le fonctionnement du circuit électronique de la figure 5 ;
- [Fig.7] La figure 7 est un chronogramme généralisant le principe de la protection d'une ligne de polarisation contre une modification du potentiel porté par une ligne de polarisation voisine ;
- [Fig.8] La figure 8 est une représentation schématique d'une variante de réalisation de l'un ou l'autres des modes de réalisation des figures 1 à 6 permettant, en outre, l'application de polarisations dynamiques sur les lignes de polarisation du circuit quantique ; et,
- [Fig.9] La figure 9 est un chronogramme représentant l'évolution temporelle des signaux du circuit de la figure 8 pour l'application de polarisations dynamiques.

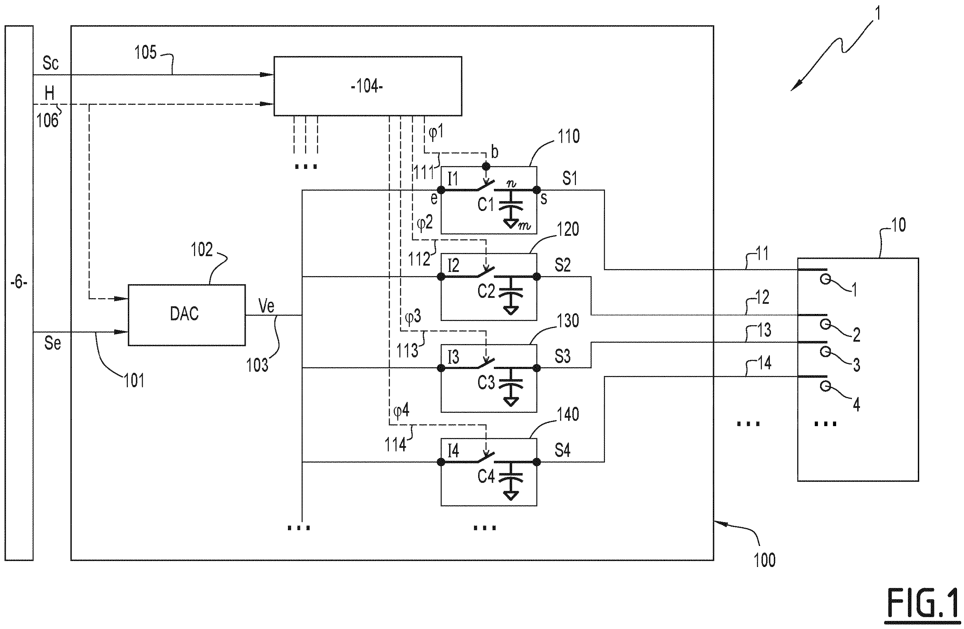

La figure 1 représente schématiquement un circuit électronique 100 selon un premier mode de réalisation de l'invention.

Le circuit électronique 100 permet de piloter un circuit quantique 10. Le circuit électronique 100 est placé en interface entre une électronique haut-niveau 6 et le circuit quantique 10. L'électronique haut-niveau 6, le circuit 100 et le circuit quantique 10 appartiennent par exemple à un calculateur quantique 1. Ce dernier comporte bien d'autres composants qui ne sont pas représentés sur la figure 1.

Le circuit quantique 10 est un dispositif à qubits, en particulier à qubits de spin. Il comporte par exemple une pluralité de 1024 qubits disposés selon une colonne (matrice unidimensionnelle - 1D). Sur la figure 1, seuls les quatre premier qubits 1, 2, 3 et 4 ont été représentés schématiquement à des fins d'illustration.

Le circuit électronique 100 est connecté à une pluralité de lignes de polarisation du circuit quantique 10. Sur la figure 1, seules quatre lignes de polarisation 11, 12, 13 et 14 ont été représentées.

Dans le mode de réalisation représenté sur les figures, chaque ligne de polarisation est associée à un qubit du circuit quantique 10. Plus précisément, l'extrémité proximale d'une ligne de polarisation est connectée au circuit électronique 100, tandis que l'extrémité distale de cette ligne de polarisation est située à proximité du qubit associé. La polarisation de la ligne de polarisation à un potentiel statique donné permet la conformation du puits quantique du qubit associé.

En pratique, chaque ligne de polarisation peut ne pas être associée à un unique qubit, mais à plusieurs qubits, par exemple une rangée de qubits dans une disposition matricielle bidimensionnelle - 2D des qubits. De même, aussi bien dans une disposition matricielle 1D que 2D, il peut y avoir plusieurs lignes de polarisation pour un qubit, ou une ligne de polarisation pour plusieurs qubits (par exemple entre deux qubits voisins afin de délimiter le « bord » de deux puits quantiques mitoyens).

Les lignes de polarisations circulent en parallèle les unes des autres. Compte tenu de la proximité de deux qubits voisins, la distance entre deux lignes de polarisation voisines est faible, de sorte qu'un couplage capacitif parasite s'établit entre ces deux lignes voisines. Typiquement, la distance entre deux qubits est typiquement de 100 nm, et l'espacement entre deux lignes de polarisation voisines peut être de moins de 50 nm.

Le circuit 100 comporte un convertisseur numérique analogique - DAC 102, un bloc de génération de signaux de commande 104 et une pluralité de cellules mémoire analogiques.

Le nombre de cellules est égal au nombre de lignes de polarisation. Sur la figure 1, seules les quatre premières cellules mémoire analogiques ont été représentées. Elles sont référencées respectivement 110, 120, 130, 140.

Dans le présent mode de réalisation, les différentes cellules de la pluralité de cellules mémoire analogique ont une structure identique.

Cette structure va maintenant être détaillée pour la première cellule 110.

La cellule 110 comporte une entrée e et une sortie s, ainsi qu'une borne de commande b.

La cellule 110 comporte, entre son entrée e et un noeud intermédiaire n, un interrupteur commandé I1. L'interrupteur I1 est commandé en ouverture ou en fermeture par un signal de commande binaire ϕ1, appliqué en sortie du bloc 104 sur une liaison 111 reliant la borne b de la cellule 110.

La cellule 110 comporte en outre, entre le noeud intermédiaire n et un noeud de référence m (porté à un potentiel de référence comme le potentiel de masse du circuit 100) une capacité C1.

La sortie s de la cellule est connectée directement au noeud intermédiaire n.

De manière similaire, la seconde cellule 120 est munie d'un interrupteur I2 (dont l'état passant ou bloquant est commandé par un signal ϕ2 appliqué en sortie du bloc 104 sur une liaison 112 reliant la borne de commande de la seconde cellule) et une capacité C2, la troisième cellule 130 est munie d'un interrupteur I3 (dont l'état est commandé par un signal ϕ3 appliqué en sortie du bloc 104 sur une liaison 113 reliant la borne de commande de la troisième cellule) et une capacité C3, et la quatrième cellule 140 est munie d'un interrupteur I4 (dont l'état est commandé par un signal ϕ4 appliqué en sortie du bloc 104 sur une liaison 114 reliant la borne de commande de la quatrième cellule) et une capacité C4.

L'entrée des différentes cellules mémoire est connectée en sortie du DAC 102 par une ligne 103. Ainsi, les différentes cellules mémoire sont placées en parallèle les unes des autres en sortie du DAC 102. La tension analogique Ve, délivrée par le DAC 102, est appliquée simultanément aux entrées des cellules de la pluralité de cellules mémoire, notamment des cellules 110, 120, 130 et 140.

La sortie d'une cellule mémoire est connectée directement à l'extrémité proximale d'une seule ligne de polarisation du circuit quantique 10. Ainsi, la sortie de la première cellule 110 est connectée à la ligne de polarisation 11, la sortie de la seconde cellule 120 est connectée à la ligne de polarisation 12, la sortie de la troisième cellule 130 est connectée à la troisième ligne de polarisation 13, et la quatrième cellule 140 est connectée à la ligne de polarisation 14.

Chaque cellule mémoire délivre un signal de polarisation de la ligne de polarisation associée. Ce signal de polarisation est un niveau de potentiel statique (évalué par rapport au potentiel de référence). Ainsi, la première cellule 110 délivre un signal de polarisation S1, la seconde cellule 120 délivre un signal de polarisation S2, la troisième cellule 130 délivre un signal de polarisation S3, et la quatrième cellule 140 délivre un signal de polarisation S4.

Le DAC 102 génère la tension analogique Ve à partir d'un signal numérique de pilotage Se provenant de l'électronique haut niveau 6. Le signal Se est appliqué sur la liaison d'entrée 101 du circuit 100.

Le bloc de génération de signaux de commande 104 génère les différents signaux de commande des différentes cellules mémoire à partir d'un signal d'adressage Sc provenant de l'électronique haut niveau 6. Le signal Sc est appliqué sur la liaison d'entrée 105 du circuit 100.

Pour synchroniser le DAC 102 et le bloc 104 (c'est-à-dire la génération des signaux de commande des cellules mémoire et la tension analogique Ve appliquée en entrée des cellules mémoire), ces deux composants partagent un signal d'horloge commun H. Celui-ci est par exemple délivré par l'électronique haut-niveau 6 sur la liaison d'entrée 106 du circuit 100.

Ainsi, selon l'invention, une ligne de polarisation est connectée directement en sortie d'une cellule mémoire. Il y a donc autant de cellules mémoire que de lignes de polarisation permettant de contrôler le circuit quantique 10.

L'ensemble des interrupteurs des cellules mémoire, en association avec le bloc 104, peut être vu comme un démultiplexeur permettant d'appliquer la valeur courante de la tension analogique Ve générée en sortie du DAC 102, à la ligne de polarisation que l'on souhaite polariser au niveau de potentiel statique correspondant à la valeur courante de la tension analogique.

Plus précisément, l'interrupteur I1 de la cellule 110 est d'abord fermé. La tension d'entrée Ve permet alors de charger la capacité C1 de sorte que le noeud intermédiaire n (et par conséquent la ligne 11) est porté au niveau de potentiel statique correspondant à la valeur courante de la tension analogique Ve. La capacité C1 « mémorise » ce niveau de potentiel statique. Dans l'état fermé de l'interrupteur 11, l'impédance de la ligne 11 est basse.

L'interrupteur 11 est ensuite ouvert. Dans l'état ouvert de l'interrupteur 11, la capacité C1 maintient le noeud intermédiaire n (et par conséquent la ligne 11) au niveau de potentiel mémorisé. Dans cet état ouvert de l'interrupteur 11, l'impédance de la ligne 11 est haute.

Une ligne de polarisation, comme la ligne 11, étant un conducteur ouvert (aucune charge n'est connectée à l'extrémité distale de la ligne de polarisation du côté du circuit quantique), il n'y a pas de consommation de charge électrique le long d'une ligne de polarisation. De plus, d'éventuelles fuites de charges électriques sont extrêmement faibles puisque les cellules mémoire et les lignes de polarisation sont situées dans le domaine cryogénique. Le diélectrique de la capacité C1 ou le diélectrique entre les lignes de polarisation 11-14 étant de bons isolants, les fuites viennent principalement de l'état résistif fini de l'interrupteur I1 (dans l'état ouvert). L'interrupteur I1 étant réalisé par un transistor, son courant de fuite diminue avec la température.

En conséquence, une ligne de polarisation est portée puis maintenue au niveau de potentiel statique mémorisé par la cellule associée.

La capacité de chaque cellule mémoire est choisie de manière à être suffisamment importante par rapport à la capacité parasite entre la ligne de polarisation issue de la cellule mémoire considérée et une ligne de polarisation voisine. Cela permet de s'affranchir des effets négatifs du couplage capacitif parasite entre lignes de polarisation voisines et circulant parallèlement l'une à l'autre.

Sachant que la capacité parasite est typiquement de quelques femtofarad (fF), la valeur de la capacité statique, C1, est choisie entre 10 et 1000 fF, de préférence entre 50 et 200 fF, de préférence encore égale à 100 fF, pour des lignes de polarisation s'étendant sur une longueur de 20 µm.

En pratique, une ligne de polarisation est constituée d'une section proximale et une section distale. La section proximale permet un routage de la ligne de polarisation pour sa connexion au circuit électronique, tandis que la section distale converge vers l'endroit où le ou les puits quantiques sont à configurer. La capacité parasite affectant une ligne de polarisation est alors créée au niveau de sa section distale, par couplage avec la section distale d'une ligne de polarisation voisine. En revanche, la distance séparant deux sections proximales de lignes voisines est plus importante. Ceci permet avantageusement d'intercaler une ligne de masse entre deux sections proximales de lignes voisines. De ce fait, la section proximale d'une ligne de polarisation présente une capacité de routage. Pour atténuer les effets de la capacité parasite, il faut alors tenir compte de cette capacité de routage lors du dimensionnement de la capacité statique de la cellule mémoire.

On recherche alors une capacité statique telle que le rapport de la capacité parasite sur la capacité totale (capacité statique augmentée de la capacité de routage) soit inférieur à 1%.

Il est à noter que la valeur finale de la capacité statique est ajustée pour réaliser un compromis entre le temps de montée du potentiel sur la ligne de polarisation (lorsque l'interrupteur de la cellule est fermé et que la capacité statique doit être chargée pour mémoriser un nouveau niveau de potentiel) et l'atténuation du couplage capacitif avec les lignes voisines.

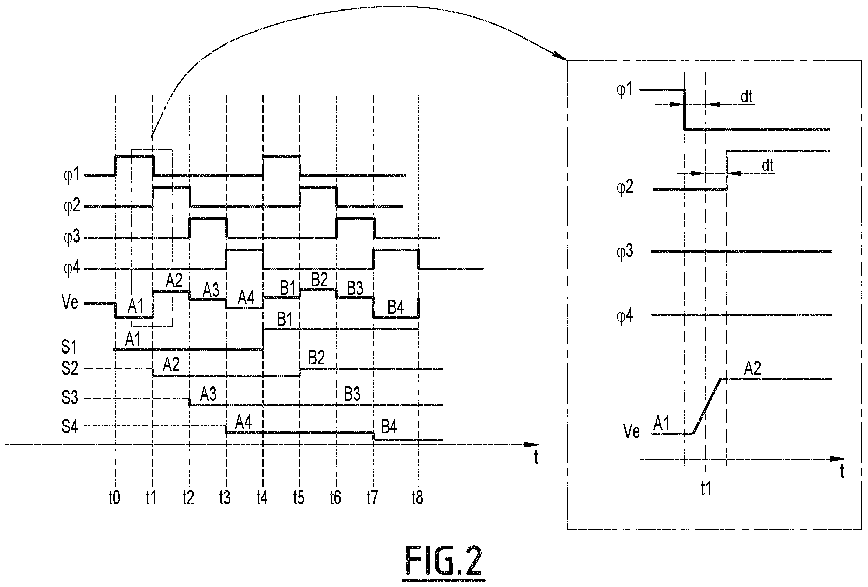

La figure 2 représente une évolution temporelle possible des différents signaux permettant un fonctionnement du circuit 100 de la figure 1. Pour des raisons de clarté de l'exposé, on se limite à présenter le fonctionnement pour les quatre lignes de polarisation 11 à 14.

Sur le chronogramme de la figure 2, le temps t est représenté en abscisse.

La tension analogique Ve est échantillonnée sur un pas de temps, par exemple de 3 ns. Elle prend successivement les valeurs A1 (entre les instants t0 et t1), A2 (entre les instants t1 et t2), A3 (entre les instants t2 et t3), A4 (entre les instants t3 et t4), B1 (entre les instants t4 et t5), B2 (entre les instants t5 et t6), B3 (entre les instants t6 et t7), B4 (entre les instants t7 et t8), etc.

Pour enregistrer la valeur A1 dans la première cellule 110, le signal de commande ϕ1 est basculé du niveau 0 au niveau 1 à l'instant t0 et est maintenu au niveau 1 sur le premier pas d'échantillonnage jusqu'à l'instant t1.

Ceci a pour effet de fermer l'interrupteur I1 de sorte que la capacité C1 mémorise le niveau de potentiel A1. En conséquence, le signal S1, sur la première ligne 11, connectée à la cellule 110, passe au niveau de potentiel A1 à l'instant t0.

Le signal de commande ϕ1 est ensuite basculé du niveau 1 au niveau 0 à l'instant t1 de sorte que l'interrupteur I1 est ouvert à partir de cet instant. Cependant, le signal S1 est maintenu au niveau de potentiel A1 par la capacité C1 qui a mémorisé le niveau de potentiel A1 lors du premier pas d'échantillonnage.

Le signal S1 est maintenu au niveau A1 sur les pas d'échantillonnage suivants, jusqu'à ce qu'un autre niveau de potentiel soit mémorisé par la première cellule 110, par exemple au cinquième pas d'échantillonnage où la tension analogique Ve prend la valeur B1 et le signal de commande ϕ1 est tel qu'il bascule en fermeture l'interrupteur I1.

A l'instant t1, la tension analogique Ve passe du niveau A1 au niveau A2.

De manière similaire, pour enregistrer la valeur A2 dans la seconde cellule 120, le signal ϕ2 passe du niveau 0 au niveau 1 sur le second pas d'échantillonnage afin de fermer l'interrupteur I2 et charger la capacité C2 au niveau de potentiel A2. Le signal S2 sur la seconde ligne 12 est porté au niveau A2 dès l'instant t1.

À l'instant t2, le signal de commande ϕ2 bascule du niveau 1 au niveau 0 conduisant à l'ouverture de l'interrupteur I2. Le niveau de potentiel A2 ayant été mémorisé par la seconde cellule 120, le signal S2 sur la seconde ligne 12 est maintenu au niveau A2. Cette valeur de polarisation est maintenue jusqu'à ce qu'une autre valeur soit enregistrée dans la seconde cellule 120, comme par exemple au sixième pas de temps où la tension analogique prend la valeur B2.

Ce processus est itéré : d'abord sur le troisième pas de temps pour enregistrer la valeur A3 du signal analogique Ve dans la troisième cellule mémoire 130 et porter le signal S3 sur la troisième ligne de polarisation 13 au niveau de potentiel statique A3 ; puis sur le quatrième pas de temps, pour enregistrer le niveau A4 de la tension analogique Ve dans la quatrième cellule 140 et porter le signal S4 sur la ligne 14 au niveau A4 ; etc.

Dans le mode de réalisation de la figure 2, les différents signaux de commande sont basculés dans le niveau 1 cycliquement, de manière à ce qu'une cellule mémoire mémorise un niveau de potentiel statique par cycle. Dans l'exemple de la figure 2, un cycle est constitué de quatre pas d'échantillonnage successifs, puisque l'on ne s'intéresse qu'aux quatre premières cellules mémoire du circuit électronique. Ainsi, au cinquième pas d'échantillonnage (premier pas du second cycle) on vient mémoriser une nouvelle valeur dans la première cellule.

A partir du chronogramme de la figure 2, on conçoit que le bloc de génération des signaux de commande 104 et le DAC 102 permettant de générer la tension analogique Ve doivent être synchronisés, afin que la valeur courante de la tension Ve que l'on souhaite enregistrer dans une cellule, coïncide avec l'instant de fermeture de l'interrupteur de cette cellule et que les changements de valeur de Ve s'opèrent lorsque les signaux de commande sont dans le niveau '0'.

Comme représenté sur la partie droite de la figure 2, un signal de commande, comme par exemple le signal ϕ1, est tel que, suite à la mémorisation d'une valeur, il doit commander la réouverture de l'interrupteur I1 de la première cellule mémoire 110 avant que la valeur de la tension Ve ne soit modifiée, afin d'être certain que c'est bien la valeur A1 qui est mémorisée dans cette première cellule. De manière similaire, le signal de commande, comme par exemple le signal ϕ2, est tel que, pour mémoriser une valeur, il doit commander la fermeture de l'interrupteur I2 de la seconde cellule mémoire 120 uniquement lorsque la valeur de la tension Ve est établie, ceci afin d'être certain que c'est bien la valeur A2 qui est mémorisée dans cette seconde cellule.

En conséquence, deux signaux de commandes ne se recouvrent pas mutuellement pour éviter que l'interrupteur de la cellule dans laquelle on vient d'enregistrer une valeur reste fermé, alors que le tension Ve passe à la valeur que l'on souhaite enregistrer dans l'autre cellule. On peut dire que le niveau '1' des signaux de commande est exclusif, alors que le niveau '0' est partagé.

L'intervalle 2dt autour de l'instant de transition de la valeur de la tension Ve permet également de tenir compte de la dynamique du DAC 102 et de la pente nécessaire pour passer d'une valeur à la suivante de la tension analogique Ve.

Ainsi, selon l'invention, le niveau de polarisation statique auquel une ligne de polarisation doit être portée à l'instant courant est stocké dans la cellule mémoire associée à cette ligne.

Lorsque l'on souhaite modifier le niveau de polarisation de cette ligne, il convient de commander en fermeture l'interrupteur de la cellule tout en appliquant une tension d'entrée dont la valeur est adaptée pour charger la capacité et porter la ligne au niveau de polarisation souhaité, puis de commander en fermeture l'interrupteur de la cellule, afin de maintenir la ligne au niveau de polarisation souhaité venant d'être enregistré.

Il est donc nécessaire d'itérer ces étapes pour modifier le niveau de polarisation d'une ligne de polarisation, au cours du fonctionnement du circuit quantique 10.

Il est à noter que, par rapport à l'état de la technique mentionné en introduction de la présente demande de brevet, on s'affranchit d'une matrice de commutation en connectant directement une ligne de polarisation à une cellule mémoire. Cette connexion directe est nécessaire pour que la capacité de la cellule mémoire joue son rôle d'atténuation des perturbations causées par la capacité parasite entre lignes voisines.

Cependant, les effets négatifs du parasitage capacitif peuvent être davantage atténués en jouant sur le phasage des signaux de commande, comme cela va maintenant être présenté en relation avec les second et troisième modes de réalisation.

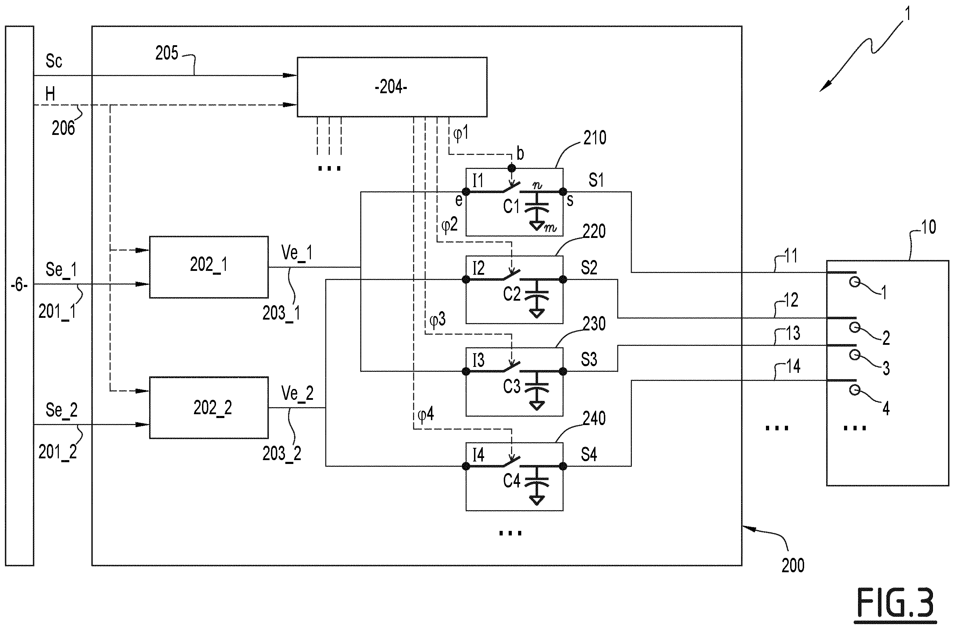

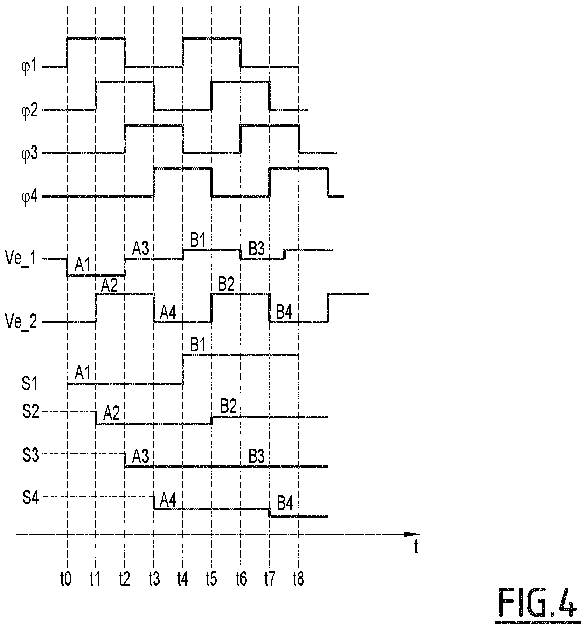

Les figures 3 et 4 représentent un second mode de réalisation du circuit selon l'invention.

Un composant du circuit 200 de la figure 3 qui est identique ou similaire à un composant du circuit 100 de la figure 1 est identifié par un chiffre de référence augmenté d'une centaine par rapport au chiffre de référence utilisé sur la figure 1 pour identifier ce composant identique ou similaire.

Le circuit 200, commandé par une électronique haut niveau 6, est destiné à porter les lignes de polarisation 11, 12, 13 et 14 du circuit quantique 10 à des potentiels souhaités.

Le circuit 200 comporte un premier DAC 202_1 propre à délivrer, sur une ligne de sortie 203_1, une première tension analogique Ve_1, et un second DAC 202_2 propre à délivrer, sur une ligne de sortie 203_2, une seconde tension analogique Ve_2.

Le premier DAC 202_1 est commandé par un signal numérique de pilotage statique Se_1 appliqué sur une entrée 201_1 du circuit 200 par l'électronique haut niveau 6 et le second DAC 202_2 est commandé par un signal numérique de pilotage statique Se_2 appliqué sur une entrée 201_2 du circuit 200 par l'électronique haut niveau 6.

Tout comme pour le premier mode de réalisation, le circuit 200 comporte une pluralité de cellules mémoire, dont seules les quatre premières, respectivement 210, 220, 230, 240, sont représentées sur la figure 3. La structure de ces cellules est identique à celle des cellules de la figure 1.

La première cellule mémoire 210 applique un signal de polarisation S1 sur la première ligne 11. La seconde cellules mémoire 220 applique un signal de polarisation S2 sur la seconde ligne 12. La troisième cellule mémoire 230 applique un signal de polarisation S3 sur la troisième ligne 13. Enfin, la quatrième cellule de mémoire 240 applique un signal de polarisation S4 à la quatrième ligne 14.

Chaque cellule est commandée par un signal de commande délivré par le bloc 204. Ainsi, la première cellule 210 est commandée par un premier signal ϕ1, la seconde cellule 220 est commandée par un second signal ϕ2, la troisième cellule 230 est commandée par un signal ϕ3 et la quatrième cellule 240 est commandée par un signal ϕ4.

Le bloc 204 de génération des signaux de commande est piloté par un signal d'adressage Sc provenant de l'électronique haut niveau 6 appliqué sur une entrée 205 du circuit 200.

Enfin, le bloc de génération des signaux de commande 204 et les premier et second DAC 202_1 et 202_2 partagent un signal d'horloge H commun, fourni par exemple par l'électronique haut niveau 6 sur une liaison 206.

Dans ce second mode de réalisation, les cellules mémoire de rang impair 2N+1 (N étant un nombre entier supérieur ou égal à zéro), telles que les première et troisième cellules 210 et 230, sont connectées en parallèle en sortie du premier DAC 202_1. La tension analogique Ve_1 est donc appliquée en entrée des cellules impaires.

En revanche, les cellules mémoire de rang pair 2N+2, telles que les seconde et quatrième cellules 220 et 240, sont connectées en parallèle en sortie du second DAC 202_2. La tension analogique Ve_2 est donc appliquée aux cellules paires.

Il est à noter qu'une ligne de polarisation issue d'une cellule mémoire paire, telle que la ligne 12 issue de la cellule 220, a comme lignes voisines, des lignes issues de cellules impaires, en l'occurrence les lignes 11 et 13 issues respectivement des cellules mémoire 210 et 230. Inversement, une ligne impaire a comme voisines deux lignes paires.

En se reportant au chronogramme de la figure 4, la tension analogique, Ve_1 générée par un DAC, 202_1 ou Ve_2 générée par le DAC 202_2, change de valeur tous les deux pas d'échantillonnage.

Au cours d'un cycle permettant d'adresser successivement les quatre cellules mémoire, la première tension analogique Ve_1 permet d'enregistrer des niveaux de polarisation uniquement dans les cellules impaires, 210 et 230, tandis que la seconde tension analogique Ve_2 permet de mémoriser des niveaux de polarisation uniquement dans les cellules paires, 220 et 230.

Ainsi par exemple, la première tension analogique Ve_1 prend la valeur A1 sur les premier et second pas d'échantillonnage (entre les instants t0 et t2) et la valeur A3 sur les troisième et quatrième pas d'échantillonnage (entre les instants t2 et t4), tandis que la seconde tension Ve_2 prend la valeur A2 sur les second et troisième pas d'échantillonnage (entre les instants t1 et t3) et la valeur A4 sur les quatrième et cinquième pas d'échantillonnage (entre les instants t3 et t5).

Il y a donc un décalage d'un pas d'échantillonnage entre les fronts de changement de valeur des tensions analogiques en sortie des deux DAC.

Dans ce second mode de réalisation, le signal de commande ϕ1 est placé dans le niveau '1' durant non seulement le premier pas d'échantillonnage, mais également le second pas d'échantillonnage, pour enregistrer la valeur A1 de la tension Ve_1 dans la cellule 210. La ligne 11 est alors portée au niveau de potentiel A1 à partir de l'instant t0 et est maintenu à cette valeur jusqu'à l'instant t4 (où une nouvelle valeur B1 sera mémorisée dans la première cellule 210).

De même, le signal de commande ϕ2 est placé dans le niveau '1' durant non seulement le second pas d'échantillonnage, mais également le troisième pas d'échantillonnage, pour enregistrer la valeur A2 de la tension Ve_2 dans la cellule 220. La ligne 12 est alors portée au niveau de potentiel A2 à partir de l'instant t1 et est maintenu à cette valeur jusqu'à l'instant t5 (où une nouvelle valeur B2 sera mémorisée dans la seconde cellule 220).

En maintenant le signal de commande ϕ1 dans le niveau 1 au-delà de l'instant t1, c'est-à-dire au-delà de l'instant de modification du niveau de potentiel sur la ligne 12 voisine de la ligne 11, le niveau de potentiel sur la ligne 11 est maintenu strictement au niveau A1. En effet, l'interrupteur I1 restant fermé à l'instant t1, la valeur courante de la tension analogique Ve_1 appliquée en entrée de la première cellule 210 contraint le potentiel de la ligne 11 au niveau A1.

Ainsi, lorsqu'on enregistre le niveau A2 dans la seconde cellule 220, la variation correspondante du signal S2 ne parasite pas le niveau A1 que l'on vient d'enregistrer dans la première cellule 210 pour définir le niveau de polarisation de la ligne 11.

La variation de potentiel d'une ligne voisine ne vient donc pas modifier le niveau de potentiel dans lequel une ligne vient d'être placée.

Ce résultat est obtenu en multipliant (de façon limitée pour ne pas augmenter le nombre de liaisons entre les domaines à température différentes) le nombre de DAC et en faisant en sorte que la fin du signal de commande permettant d'enregistrer un niveau de potentiel dans une cellule, recouvre partiellement le début du signal de commande permettant d'enregistrer un niveau de potentiel dans une cellule voisine.

Bien évidemment, ce recouvrement partiel entre les signaux de commande de cellules voisines se retrouve entre les signaux ϕ2 et ϕ3, entre les signaux ϕ3 et ϕ4, etc.

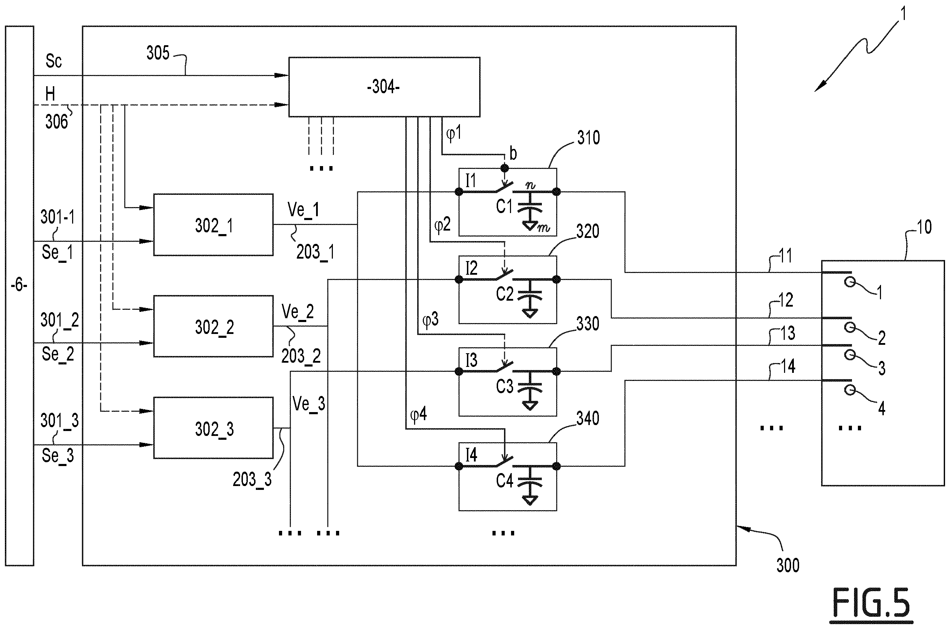

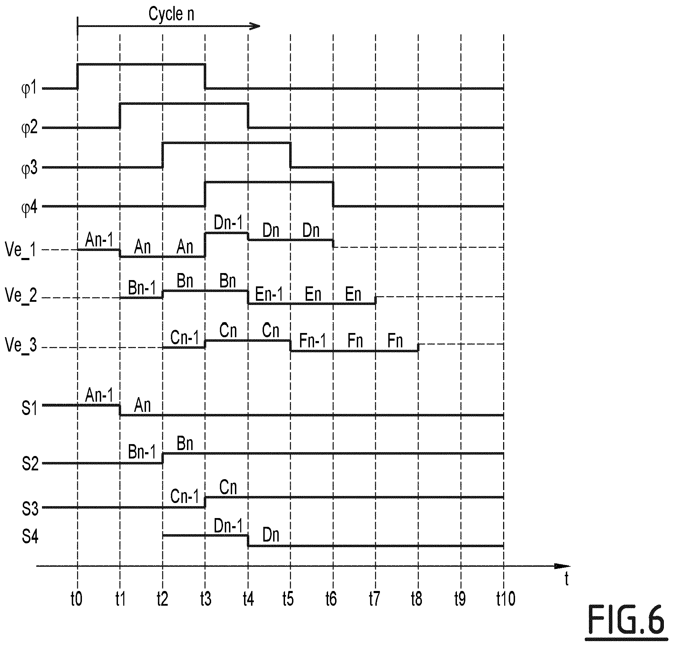

Les figures 5 et 6 sont relatives à un troisième mode de réalisation du circuit selon l'invention.

Un composant du circuit 300 de la figure 5 qui est identique ou similaire à un composant du circuit 100 de la figure 1 est identifié par un chiffre de référence augmenté de deux centaines par rapport au chiffre de référence utilisé sur la figure 1 pour identifier ce composant identique ou similaire.

Le circuit 300 est destiné à définir les niveaux de potentiels auxquels sont portés les lignes de polarisation 11, 12, 13, et 14 associées aux qubits du circuit quantique 10.

Le circuit 300, qui est commandé par une électronique haut-niveau 6, comporte un premier DAC 302_1 (piloté par un signal numérique de pilotage Se_1 appliqué sur une entrée 301_1 du circuit 300 par l'électronique haut niveau 6), un second DAC 302_2 (piloté par un signal numérique de pilotage Se_2 appliqué sur une entrée 301_2 du circuit 300 par l'électronique haut niveau 6) et un troisième DAC 302_3 (piloté par un signal numérique de pilotage Se_3 appliqué sur une entrée 301 _3 du circuit 300 par l'électronique haut niveau 6).

En sortie du premier DAC 302_1, la tension analogique Ve_1 est appliquée aux cellules mémoire de rang 3N+1 (où N est un nombre entier), comme les cellules mémoire 310 et 340.

En sortie du second DAC 302_2, la tension analogique Ve_2 est appliquée aux cellules mémoire 3N+2, comme la cellule 320.

Enfin, en sortie du troisième DAC 302_3, la tension analogique Ve_3 est appliquée aux cellules mémoire de range 3N+3, comme la cellule mémoire 330.

Chacune des cellules mémoire présente une structure identique à celle de la cellule 110 du premier mode de réalisation de la figure 1.

Chacune des cellules est commandée par un signal de commande généré par le bloc 304 à partir d'un signal d'adressage Sc appliqué sur une entrée 305 du circuit 300 par l'électronique haut-niveau 6.

Le bloc 304 et les trois DAC sont synchronisés par un signal d'horloge H commun appliqué par exemple sur l'entrée 306 du circuit 300.

La figure 6 est un chronogramme des signaux intervenant dans le fonctionnement du circuit 300 pour une programmation cyclique des signaux sur les lignes de polarisation.

La programmation du signal Si sur la ligne de rang i au cours du nième cycle comporte trois phases successives : un rappel du potentiel mémorisé au cycle précédent alors que le potentiel sur l'une des deux lignes voisines est modifié ; la mémorisation d'un nouveau potentiel et le maintien de ce nouveau potentiel alors que le potentiel sur l'autre des deux lignes voisines est modifié.

Par exemple, si l'on suit plus particulièrement le fonctionnement de la seconde cellule 320 au cours du cycle n.

Le signal de commande ϕ2 est basculé du niveau 0 au niveau 1 entre les instants t1 et t4, c'est-à-dire sur trois pas d'échantillonnage.

La tension analogique Ve_2, appliquée en entre de la seconde cellule 320, est élaborée de manière à prendre la valeur Bn-1 entre les instants t1 et t2, et la valeur Bn entre les instants t2 à t4. La valeur Bn-1 est celle qui a été mémorisée par la seconde cellule 320 au cours du cycle précédent, n-1, et Bn est celle que l'on souhaite mémoriser dans la seconde cellule 320 au cours du cycle courant, n, puis maintenir dans la seconde cellule.

Le fait que le signal de commande ϕ2 soit dans le niveau 1 entre les instants t1 et t2, c'est-à-dire lorsque la valeur de la tension Ve_2 vaut Bn-1, permet de contraindre le potentiel de la seconde ligne 12 à la valeur Bn-1. Le potentiel auquel la ligne 12 est portée depuis le cycle précédent n'est donc pas altéré par la modification du potentiel sur la ligne voisine 11 à l'instant t1 (le signal S1 passant de la valeur An-1 à la valeur An).

Le fait que le signal de commande ϕ2 soit dans le niveau 1 entre les instants t2 et t3, c'est-à-dire lorsque la valeur de la tension Ve_2 bascule de Bn-1 à Bn, permet de mémoriser cette nouvelle valeur dans la seconde cellule 320 et de porter le potentiel de la seconde ligne 12 à la valeur Bn.

Le fait que le signal de commande ϕ2 soit dans le niveau 1 entre les instants t3 et t4, c'est-à-dire lorsque la valeur de la tension Ve_2 est maintenu à Bn, permet de contraindre le potentiel de la seconde ligne 12 à la valeur Bn. Le potentiel auquel la ligne 12 est portée depuis l'instant t2 n'est donc pas altéré par la modification du potentiel sur la ligne voisine 13 à l'instant t3 (le signal S3 passant de la valeur Cn-1 à la valeur Cn).

Une description similaire pourrait être faite pour, au cycle n, l'enregistrement et le maintien du potentiel An dans la première cellule, du potentiel Cn dans la troisième cellule, du potentiel Dn dans la quatrième cellule, du potentiel En dans une cinquième cellule, du potentiel Fn dans une sixième cellule, etc.

On constate que dans cette approche, le signal de commande d'une cellule prend le niveau '1' durant un intervalle de temps recouvrant les changements de potentiel sur les deux lignes voisines, non seulement pour permettre de porter la ligne issue de cette cellule à un nouveau niveau de potentiel, mais également pour maintenir le niveau de potentiel porté par cette ligne, alors que les potentiels sur les deux lignes voisines sont modifiés.

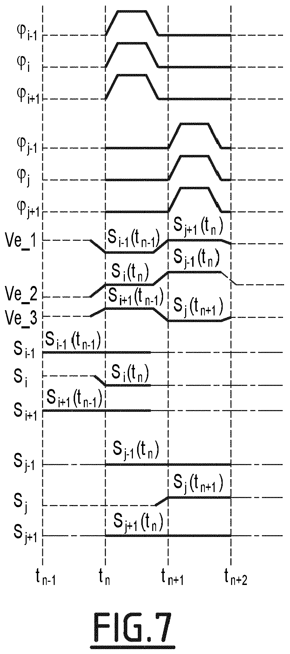

On peut généraliser cette approche à des programmations non cycliques. Ceci est illustré sur la figure 7.

Une ligne de polarisation de rang i circule entre deux lignes de polarisation voisines de rang i-1 et i+1 respectivement.

Une ligne de polarisation de rang j circule entre deux lignes de polarisation voisines de rang j-1 et j+1 respectivement.

Pour une telle topologie, il faut donc trois DAC délivrant respectivement une première tension analogique Ve_1, une seconde tension analogique Ve_2 et une troisième tension analogique Ve_3.

Sans perte de généralité, on considère que i est égal à 2 modulo 3, c'est-à-dire que les valeurs du signal Si sur la ligne de rang i sont données par la seconde tension Ve_2. Par conséquent, les valeurs du signal Si-1 sur la ligne voisine de rang i-1 sont données par la première tension Ve_1 et les valeurs du signal Si+1 sur la ligne voisine de rang i+1 sont données par la troisième tension Ve_3.

Si on fait l'hypothèse que la ligne de rang j-1 n'est pas voisine de la ligne de rang i, c'est-à-dire qu'au moins deux lignes séparent les lignes de rang i et j.

Si à l'instant tn on souhaite porter la ligne de rang i au potentiel Si(tn), il convient qu'à l'instant tn les signaux de commande cpi-1, ϕi et cpi+1 basculent dans l'état passant les cellules associées aux lignes de rang i-1, i et i+1 et que les valeurs des tensions analogiques à cet instant soient :
- pour la première tension Ve_1 (appliquée à la ligne i-1), égale à Si-1(tn-1), c'est-à-dire la valeur précédemment mémorisée pour la ligne i-1, afin de maintenir le potentiel de cette ligne voisine ;
- pour la seconde tension Ve_2 (appliquée à la ligne i), égale à Si(tn), c'est-à-dire la valeur à mémoriser sur la ligne i ; et,
- pour la première tension Ve_3 (appliquée à la ligne i+1), égale à Si+1(tn-1), c'est-à-dire la valeur précédemment mémorisée pour la ligne i+1, afin de maintenir le potentiel de cette ligne voisine lors de la modification du potentiel sur la ligne i.

Au pas de temps suivant tn+1, une description similaire pourrait être faite pour montrer comment protéger les lignes j-1 et j+1 voisines de la ligne j dont on souhaite modifier le potentiel. Sur la figure 7, on considère par exemple que j est égal à 0 modulo 3, c'est-à-dire que les valeurs du signal Sj sur la ligne de rang j sont données par la troisième tension Ve_3 et que les valeurs du signal Sj-1 sur la ligne j-1 sont données par la seconde tension Ve_2 et les valeurs du signal Sj+1 sur la ligne j+1 sont données par la première tension Ve_1.

Si maintenant il y a une collision telle que par exemple la ligne i+1 est également la ligne j-1, pour protéger la ligne i+1 à la fois d'une modification du potentiel sur la ligne i à l'instant tn et d'une modification du potentiel sur la ligne j à l'instant tn+1, il suffit de maintenir le signal de commande cpi+1 au niveau 1 sur les pas tn et tn+1 et d'appliquer une tension analogique en entrée de la cellule i+1 égale à Si+1 (tn-1) pour contraindre et donc maintenir le potentiel sur cette ligne i+1.

Ce mécanisme de maintien des potentiels sur les lignes de polarisation voisines permet de garantir, à tout instant du fonctionnement, une précision sur le potentiel d'une ligne inférieure à 100µV.

On notera que le recours à trois DAC est conditionné par la topologie du circuit quantique. En effet, dans le mode de réalisation présenté, les lignes de polarisation sont routées dans un unique niveau, de sorte qu'une ligne a deux lignes voisines. Il est donc nécessaire d'avoir trois DAC pour maîtriser le potentiel porté par chacune des lignes de ce groupe de lignes. En variante, avec un routage sur plusieurs niveaux, une ligne peut avoir K lignes voisines, par exemple six dans une topologie hexagonale. Dans ce cas il peut être avantageux d'utiliser K+1 DAC.

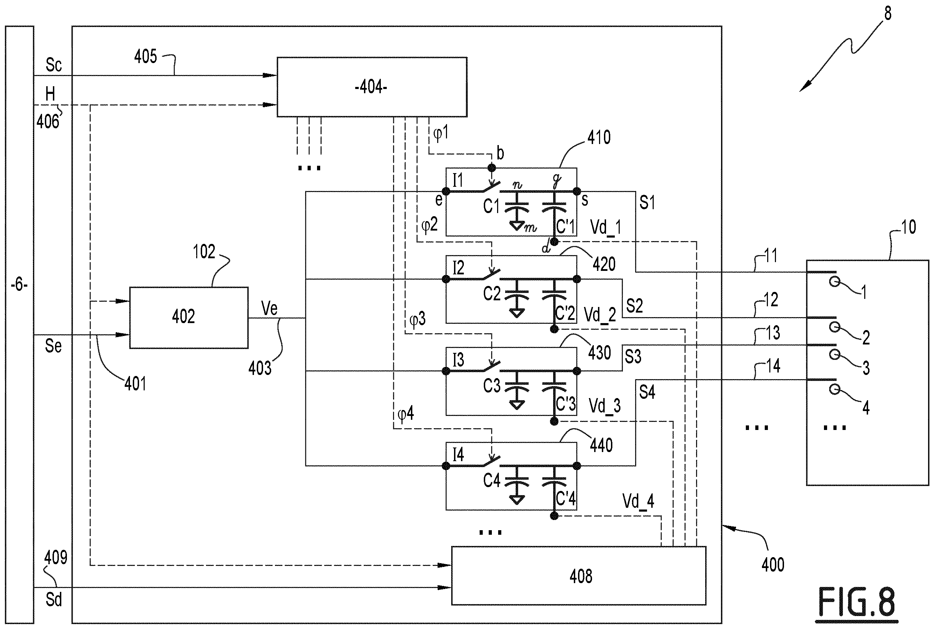

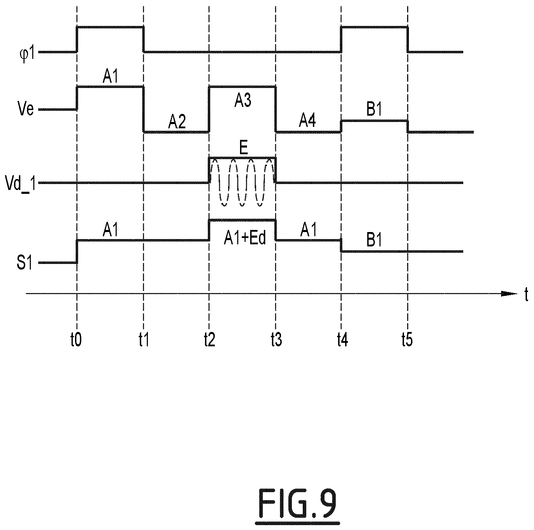

Les figures 8 et 9 représentent une variante de réalisation particulièrement avantageuse, présentée pour le premier mode de réalisation, mais pouvant s'appliquer à l'un ou l'autre des modes de réalisation précédents.

Cette variante de réalisation permet d'appliquer une polarisation dynamique sur l'une ou l'autre des lignes de polarisation.

En effet, au-delà de la nécessité de porter une ligne de polarisation à un potentiel statique pour conformer le puits quantique du qubit correspondant, il est également avantageux de pouvoir appliquer, via cette même ligne de polarisation, une polarisation dynamique. L'application d'une polarisation dynamique de fréquence déterminée permet par exemple l'identification des signatures fréquentielles des qubits lus par un même dispositif de lecture, la modification de la configuration de plusieurs qubits de façon parallèle, ou encore l'activation et le couplage des spins entre qubits proches. Le document FR 2 012 968 décrit l'application d'une telle polarisation dynamique du côté du circuit quantique à piloter.

Un composant du circuit 400 de la figure 8 qui est identique ou similaire à un composant du circuit 100 de la figure 1 est identifié par un chiffre de référence augmenté de trois centaines par rapport au chiffre de référence utilisé sur la figure 1 pour identifier ce composant identique ou similaire.

Le circuit 400 comporte un unique DAC 402 connecté en sortie à quatre cellules mémoire 410, 420, 430 et 440.

La structure de ces cellules est modifiée par rapport à celle des cellules des modes de réalisation des figures 1, 3 et 5.

Sur l'exemple de la cellule 410, outre l'interrupteur I1, qui est connecté entre l'entrée e et le noeud intermédiaire n et qui est commandé en ouverture ou en fermeture par un signal de commande ϕ1 appliqué sur une borne b, et une capacité « statique » C1, qui est connectée entre le noeud intermédiaire n et le noeud de référence m, la cellule mémoire comporte une seconde capacité « dynamique », C'1, montée en parallèle de la capacité statique C1, entre un noeud intermédiaire g et une borne d'alimentation d de la cellule mémoire. La sortie s de la cellule (à laquelle est connectée la ligne de polarisation 11) est connectée directement au noeud g (ou au noeud n).

Dans cette variante de réalisation, le noeud d'alimentation d de chacune des cellules est connecté à un bloc 408 de génération d'une tension analogique alternative : Vd_1 pour la première cellule 410, Vd_2 pour la seconde cellule 420, Vd_3 pour la troisième cellule 430, et Vd_4 pour la quatrième cellule 440.

Le bloc 409 est piloté par un signal numérique de pilotage dynamique Sd appliquée par l'électronique haut-niveau sur une liaison d'entrée 409 du circuit 400.

Comme illustré sur la figure 9, pour le fonctionnement de la première cellule 410, le niveau de potentiel statique A1 a été enregistré dans la cellule 410 en plaçant le signal de commande ϕ1 dans le niveau 1 entre les instants t0 et t1.

Une fois le signal de commande ϕ1 ramené au niveau 0, le signal S1 est maintenu au niveau A1 par la capacité statique C1.

Entre les instants t2 et t3, la tension analogique alternative Vd_1 d'amplitude E et de fréquence F est appliquée par le bloc 408 sur la borne d de la cellule 410.

Via la capacité dynamique C'1, la variation de potentiel sur la borne d engendre une variation de potentiel au noeud g, c'est-à-dire une modification du signal S1.

Une polarisation dynamique Ed vient ainsi se superposer à la polarisation statique A1 dans le signal S1.

De préférence, l'amplitude E la tension analogique alternative Vd_1 est bien inférieure à celle de la tension analogique statique Ve. En tout état de cause, sur une ligne de polarisation, la polarisation dynamique, Ed, reste à un niveau d'amplitude faible (généralement de quelques 100 µV) par rapport à la polarisation statique, A1, (généralement de quelques mV).

Ainsi, l'ajout d'un bloc 408 pour générer des stimuli dynamiques, permet un fonctionnement complet du circuit quantique 10.

C'est la connexion directe de la ligne de polarisation en sortie d'une cellule mémoire qui permet l'injection d'une polarisation dynamique, par l'ajout d'une capacité « dynamique » dans la cellule mémoire.

Il est à noter que les modes de réalisation des figures 1 et 8 par exemple pourraient être mélangés, certaines des cellules mémoire présentant une structure permettant d'appliquer uniquement un signal statique et un petit nombre de cellules mémoire permettant d'appliquer un signal dynamique en plus du signal statique.

En variante, il peut aussi y avoir une décorrélation entre les séquencements des polarisations statique et dynamique.

En variante, il est possible d'étendre le nombre de DAC, c'est-à-dire le nombre d'entrées du circuit au-delà de trois. Les signaux de commande seront avantageusement adaptés pour neutraliser les parasitages entre lignes voisines lors d'un changement de niveau de polarisation sur ces lignes. Cela peut dépendre de la topologie spécifique retenue pour router les lignes de polarisation du circuit quantique 10.

L'intérêt du circuit selon l'invention est aussi d'autoriser un partitionnement des composants entre domaines à différentes températures 300K, 4K, 100mK, tout en conservant un nombre réduit de connexion entre le domaine 4K et le domaine 100mK. Ainsi, le ou les DAC du circuit selon l'invention, qui sont des composants actifs, peuvent être placés dans le domaine à température ambiante ou intermédiaire, tandis que le bloc de génération des signaux de commande et les différentes cellules mémoire peuvent être placés au plus près du circuit quantique, dans le domaine à température cryogénique.

En variante, les signaux de commande sont générés dans le domaine 4K et leur décodage est réalisé dans le domaine 100mK.

Il est à noter que plus le nombre de DAC augmente, plus la vitesse de ces DAC peut être réduite, mais plus le nombre d'entrées du circuit augmente et donc de ponts entre domaines de températures différentes.

En variante, une cellule mémoire pourrait avoir une autre structure. Par exemple, une cellule mémoire pourrait comporter un second bloc interrupteur / capacité en série d'un premier bloc interrupteur / capacité, chaque bloc étant conforme à la structure d'une cellule représentée sur la figure 1.

Une telle variante permet d'améliorer les performances en terme d'isolation entre entrée et sortie de la cellule mémoire par la présence des deux interrupteurs en série.

Le signal de commande du second interrupteur doit être correctement synchronisé avec le signal de commande du premier interrupteur.

Le ou chaque interrupteur d'une cellule mémoire peut par exemple être réalisé par un transistor MOS de type N. De façon avantageuse, au lieu d'utiliser un transistor MOS « brut » (« bulk »), on utilisera un transistor MOS « grille arrière en inverse » (« reverse back gate »), qui permet d'augmenter l'isolation à l'état 'bloqué' tout en diminuant la résistance de l'interrupteur à l'état 'passant'. On peut aussi combiner les types N et P pour augmenter la dynamique de fonctionnement du ou de chaque interrupteur.

Dans la présente description, le format des signaux appliqués par l'électronique haut niveau au circuit électronique de pilotage du circuit quantique n'a pas été spécifié car ce format peut être choisi sans contraintes particulières parmi les différents formats connus de l'homme du métier. En particulier, si l'on considère le nombre de liaisons entre électronique haut-niveau et circuit électronique trop important, on peut en réduire le nombre en prévoyant la sérialisation des différents signaux sur une seule liaison ou un plus petit nombre de liaison. Le circuit électronique comporte alors une interface de dé-sérialisation pour séparer chaque signal et l'adresser à un composant particulier.

## Revendications

1. Circuit électronique (100) de pilotage d'un circuit quantique, destiné à être positionné en interface entre une électronique haut-niveau (6) et le circuit quantique (10), le circuit électronique étant relié au circuit quantique par une pluralité de lignes de polarisation (11, 12, 13, 14), une ligne de polarisation étant portée à un potentiel de contrôle d'une configuration d'un qubit (1, 2, 3, 4) du circuit quantique, le circuit électronique comportant :
- au moins un convertisseur numérique analogique - DAC (102) délivrant une tension analogique (Ve) à partir d'un signal numérique de pilotage statique (Se) fourni par l'électronique haut-niveau ;
- une pluralité de cellules mémoire (110, 120, 130, 140), connectées en parallèle en sortie du convertisseur numérique analogique, chaque cellule mémoire comportant, entre une entrée et un noeud intermédiaire, un interrupteur commandé (I1, I2, I3, I4), et, entre le noeud intermédiaire et un noeud porté à un potentiel de référence, une capacité dite statique (C1, C2, C3, C4), la sortie de la cellule mémoire étant reliée au noeud intermédiaire, la capacité statique étant capable de mémoriser un niveau de potentiel statique auquel maintenir une ligne de polarisation de la pluralité de lignes de polarisation qui est connectée en sortie de la cellule mémoire ; et,
- un moyen de génération de signaux de commande (104) adapté pour générer, en synchronisation avec le DAC, à partir d'un signal d'adressage (Sc) fourni par l'électronique haut-niveau, un signal de commande associé à chaque cellule mémoire, le signal de commande associé à une cellule mémoire étant adapté pour basculer l'interrupteur commandé de la cellule mémoire entre un état bloquant et un état passant,
- une valeur de la capacité statique d'une cellule mémoire étant sélectionnée pour rendre négligeable une capacité parasite affectant une section distale de la ligne de polarisation reliée à ladite cellule mémoire et qui circule parallèlement à une section distale d'une ligne de polarisation voisine, le circuit électronique étant **caractérisé en ce que**, pour une cellule mémoire courante de la pluralité de cellules mémoire, le signal de commande bascule l'interrupteur de ladite cellule mémoire courante dans l'état passant alors qu'une valeur courante de la tenson analogique (Ve) appliquée en entrée de ladite cellule mémoire courante est égale soit à un niveau de potentiel à mémoriser dans ladite cellule mémoire courante, soit un niveau de potentiel déjà mémorisé dans ladite cellule mémoire courante et à maintenir dans ladite cellule mémoire courante alors qu'une modification est réalisée sur le niveau de potentiel mémorisé par une cellule mémoire voisine, la cellule mémoire voisine étant une cellule mémoire de la pluralité de cellules mémoire à laquelle est reliée une ligne voisine de la ligne de polarisation reliée à la cellule mémoire courante.

2. Circuit électronique selon la revendication 1, dans lequel la ligne de polarisation reliée à la cellule mémoire comporte une section proximale présentant une capacité de routage, la valeur de la capacité statique étant sélectionnée en tenant compte de la capacité de routage de la section proximale de la ligne de polarisation.

3. Circuit électronique selon la revendication 1 ou la revendication 2, dans lequel la section distale de la ligne de polarisation reliée à la cellule mémoire ayant une longueur entre 10 et 100µm, la valeur de la capacité statique (C1) est sélectionnée entre 10 et 1000 fF, de préférence entre 50 et 200 fF, de préférence encore égale à 100 fF.

4. Circuit électronique (400) selon l'une quelconque des revendications précédentes, dans lequel au moins une cellule mémoire (410) de la pluralité de cellules mémoire comporte, en outre, une capacité dite dynamique (C'1), connectée entre le noeud intermédiaire et une borne d'alimentation (d), en parallèle de la capacité statique (C1), le circuit électronique (400) comportant un bloc de génération d'une tension analogique alternative (408) piloté par un signal numérique de pilotage dynamique (Sd) fourni par l'électronique haut-niveau (6) et adapté pour appliquer une tension analogique alternative (Vd_1) à la borne d'alimentation pour porter à un potentiel dynamique, la ligne de polarisation reliée en sortie de ladite au moins une cellule mémoire.

5. Circuit électronique selon l'une quelconque des revendications précédentes, dans lequel le bloc de génération des signaux de commande et le ou chaque DAC sont synchronisés par un signal d'horloge commun.

6. Circuit électronique selon l'une quelconque des revendications précédentes, dans lequel le ou chaque DAC est positionné dans un domaine à température ambiante ou dans un domaine à température intermédiaire, dans lequel la pluralité de cellules mémoire est positionnée dans un domaine à température cryogénique, et dans lequel le bloc de génération des signaux de commande est soit intégralement positionné dans le domaine à température cryogénique, soit réparti entre le domaine à température cryogénique et un domaine parmi le domaine à température ambiante ou le domaine à température intermédiaire.

7. Circuit électronique selon l'une quelconque des revendications 1 à 6, dans lequel le DAC étant un premier DAC (202_1) et la pluralité de cellules mémoire étant une première pluralité de cellules mémoire, le circuit comporte une seconde pluralité de cellules mémoire et un second DAC (202_2), une seconde cellule mémoire (220) de la seconde pluralité de cellules mémoire étant connectée en sortie du second DAC, une seconde ligne de polarisation (12) reliée à la seconde cellule mémoire étant positionnée entre une première ligne de polarisation (11) reliée à une première cellule mémoire de la première pluralité de cellules mémoire et une troisième ligne de polarisation (13) reliée à une troisième cellule mémoire de la première pluralité de cellules mémoire.

8. Circuit électronique (300) selon l'une quelconque des revendications 1 à 6, dans lequel le DAC étant une premier DAC (302_1) et la pluralité de cellules mémoire étant une première pluralité de cellules mémoire connectées au premier DAC, le circuit comporte, d'une part, un second DAC (302-2) et une seconde pluralité de cellules mémoire connectées au second DAC, et, d'autre part, un troisième DAC (302-3) et une troisième pluralité de cellules mémoire connectées au troisième DAC, une seconde ligne de polarisation (12) reliée à une seconde cellule mémoire ayant comme lignes de polarisation voisines une première ligne de polarisation (11) reliée à une première cellule mémoire et une troisième ligne de polarisation (13) reliée à une troisième cellule mémoire.

9. Circuit électronique selon l'une des revendications précédentes, dans lequel le circuit quantique comprend un ensemble de qubits de spin auxquels sont reliées lesdites lignes de polarisation.

10. Calculateur quantique (1) comportant une électronique haut-niveau (6), un circuit électronique et un circuit quantique (10), le circuit électronique étant en interface entre l'électronique haut-niveau et le circuit quantique pour piloter la circuit quantique, **caractérisé en ce que** le circuit électronique (100, 200, 300, 400) est conforme à l'une quelconque des revendications 1 à 9.
